# EUROPEAN PATENT APPLICATION

(11) **EP 2 799 126 A1**
(43) Date of publication of application: **05.11.2014**
(21) Application number: 14158505.9
(22) Date of filing: 10.03.2014
(51) Int. Cl.: B01D 53/68, C23C 16/44

(54) **Scrubber for processing waste gas**

(30) Priority: 30.04.2013 KR 20130047839
(71) Applicant: GnBS Engineering Co., Ltd, Gyeonggi-do 456-833 (KR)
(72) Inventor: Park, Sang Soon, 463-440 Gyeonggi-do (KR); Jeong, Jongmun, 456-823 Gyeonggi-do (KR)
(74) Representative: Prugneau, Philippe

(57) **Abstract**

The present invention discloses relates to a scrubber (100) for treating process waste gas and an object of the present invention is to provide the scrubber for treating process waste gas, which utilizes a pyrolysis process and a catalytic reaction to enhance the powder by-product removal efficiency. For the above purpose, the present invention discloses the scrubber for treating process waste gas, comprising a heat source (110) for providing heat energy; an injection chamber (120) connected to the heat source to allow process waste gas to be injected thereinto; a reaction chamber (130) connected to the injection chamber and supplying catalytic gas to process waste gas introduced from the injection chamber to decompose process waste gas and form powder by-product; a first cooling unit (140) connected to the reaction chamber for cooling and collecting the powder by-product; and a filter unit (150) connected to the first cooling unit for filtering the powder by-product.

## Description

### CROSS-REFERENCE(S) TO RELATED APPLICATIONS

This application claims priority to Korean Patent Application No. 10-2013-0047839, filed on April 30, 2013, which is incorporated herein by reference in its entirety.

### BACKGROUND OF THE INVENTION

### Field of the invention

The present invention relates to a scrubber for treating process waste gas, which treats waste gas discharged in the process of manufacturing a semiconductor device, in the process of manufacturing a flat display device such as a liquid crystal display ("LCD") or an organic light emitting display ("OLED"), or in the process of manufacturing a solar cell and a light emitting diode ("LED").

### Description of the related art

In the processes such as a process of manufacturing a semiconductor device, a process of manufacturing a flat display device such as LCD or OLED and a process of manufacturing a solar cell and LED, utilizing specialty gas, waste gas (hereinafter, referred to as "process waste gas") which is harmful to the human body and the environment is generated. In order to prevent a pollution caused by such harmful substance, a purification treatment for process waste gas should be carried out before releasing process waste into the atmosphere.

Process waste gas is purified by a scrubber for treating process waste gas (for example, Korean Patent Laid-open publication No. 10-2007-0080004 (published on August 9, 2007) and then released to an outside. In general, the scrubber for treating process waste gas consists of a reaction chamber providing high-temperature heat for decomposing harmful substances contained in process waste gas or accelerating chemical reaction and a water treatment tower for filtering solid-phased powders from process waste gas passing through the reaction chamber.

Meanwhile, since process waste gas containing halogen-group elements (for example, chlorine (Cl), fluorine (F)) has been mainly treated through a wet processing, waste water is generated at the time of treating process waste gas so that cumbersome procedures such as an additional collection and treatment of waste water should be carried out.

In addition, in a case where waste gas is treated by the wet process, the treating efficiency of waste gas containing halogen-group elements (for example, chlorine (Cl), fluorine (F)) is lowered, this causes a problem..

### SUMMARY OF THE INVENTION

An object of the present invention is to provide a high efficiency scrubber for treating process waste gas, which utilizes catalytic reaction to enhance the waste gas removal efficiency.

To achieve the above technical solution, the scrubber for treating process waste gas according to one embodiment of the present invention includes a heat source for providing heat energy; an injection chamber connected to the heat source to allow process waste gas to be injected thereinto; a reaction chamber connected to the injection chamber and supplying catalytic gas to process waste gas introduced from the injection chamber to decompose process waste gas and form powder by-product; a first cooling unit connected to the reaction chamber for cooling and collecting the powder by-product; and a filter unit connected to the first cooling unit for filtering the powder by-product.

The process waste gas may contain halogen-group elements and the catalytic gas may contain ammonia (NH₃).

The scrubber for treating process waste gas of the invention may further include a catalytic gas-injecting pipe for supplying the catalytic gas connecting the first cooling unit and the filter unit to each other to collect unreacted process waste gas.

Here, the pair of first cooling units and the pair of filter units may be provided.

A plasma torch, a gas heater or an electric heater may be employed as the heat source. The first cooling unit may include a first cooling region consisting of first mesh nets and a first cooling pipe installed between the first mesh sheets; and a second cooling region spaced apart from the first cooling region, the second cooling region consisting of second mesh nets and a second cooling pipe installed between the second mesh sheets. In addition, the first cooling pipe and the second cooling pipe may be connected to the filter unit to cool the filter unit. Also, the cooling fluid may be supplied to the first cooling pipe and the second cooling pipe.

The filter unit includes a filter, and fluid except for the powder by-product may pass through the filter.

The filter unit may be further connected to a second cooling unit. The second cooling unit may include a plurality of cooling pipes on which a cooling fin is installed.

The reaction chamber may have a shape selected from a cylindrical shape, a square column shape, a pentagonal column shape, a hexagonal column shape and a polygonal column shape, the first cooling unit may have a cylindrical shape or a square column shape, and the filter unit may be formed into a shape selected from a cylindrical shape, a square column shape, a pentagonal column shape, a hexagonal column shape and a polygonal column shape.

### BRIEF DESCRIPTION OF THE DRAWINGY

FIG. 1A to FIG. 1D are plane view, front view, rear view and side view showing a scrubber for treating process waste gas according to one embodiment of the present invention;
FIG. 2A to FIG. 2C are partial sectional views showing a scrubber for treating process waste gas according to one embodiment of the present invention;
FIG. 3 is a side view showing a scrubber for treating process waste gas according to another embodiment of the present invention; and
FIG. 4 is a perspective view showing a scrubber for treating process waste gas according to yet another embodiment of the present invention.

### DETAILED DESCRIPTION OF THE PREFERRED EMBODIMENTS

Hereinafter, the preferred embodiments of the present invention will be described in detail with reference to the accompanying drawings.

The embodiments of the present invention are provided for illustrating more completely the present invention to those skilled in the art, the below embodiments may be variously modified and the scope of the present invention is not limited to the below embodiments. The below embodiments are provided for completely and faithfully conveying the spirit of the present invention to one skilled in the art.

In addition, a thickness or a size of each layer shown in the accompanying drawings is exaggerated for the convenience and clarity of explanation, and the same reference numeral in the drawings indicates the same elements/members. The term "and/or" used herein encompasses both combinations of the plurality of related items disclosed and any item from among the plurality of related items disclosed.

The terms used in the specification of the present application are used for only illustrating specific embodiments, and are not intended to limit the present invention. A singular expression used herein may include a plural expression as long as it does not have an apparently different meaning in context. In the present specification, the terms "comprise" and/or "have" should be understood to be intended to designate that illustrated features, numbers, steps, operations, members, components, parts and/or combinations thereof exist and not to preclude the existence of one or more different features, numbers, steps, operations, components, parts or combinations thereof, or the possibility of the addition thereof.

The terms including the ordinal numeral such as "first", "second", etc used herein may be used to describe various members, parts, regions, layers and/or portions. However, it is obvious that these members, parts, regions, layers and/or portions are not limited by such terms. These terms are used only for the purpose of distinguishing a member, a part, a region, a layer or a portion from other member, part, region, layer or portion. Without departing a teaching of the present invention, therefore, the first member, part, region, layer or component may designate the second member, part, region, layer or components

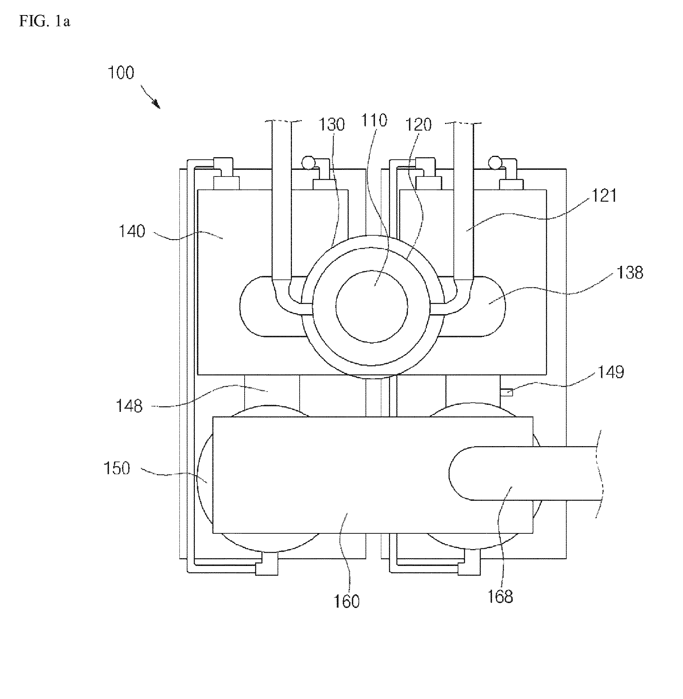

FIG. 1A to FIG. 1D are plane view, front view, rear view and side view showing a scrubber 100 for treating process waste gas according to one embodiment of the present invention.

As shown in FIG. 1A to FIG. 1D, the scrubber 100 for treating process waste gas according to the present invention includes a heat source 110 for providing heat energy, an injection chamber 120 into which process waste gas is supplied, a reaction chamber 130 in which catalytic gas is supplied and is reacted with process waste gas, a first cooling unit 140 in which power by-product is formed, a filter unit 150 for filtering the powder by-product and a second cooling unit 160 for cooling discharge gas to a room temperature (approximately 25 °C) and discharging it to an outside.

The scrubber 100 for treating process waste gas treats process waste gas containing halogen-group elements such as chlorine (Cl) and fluorine (F).

The heat source 110 is installed at an uppermost end of the scrubber 100 and provides the activation energy to enable process waste gas containing chlorine (Cl₂) to be decomposed and dissociated. Any one selected from a plasma torch, a gas heater, an electric heater and an equivalent thereof may be employed as the heat source 110. However, the above does not limit the present invention. For example, the plasma torch is utilized as the heat source 110, the temperature of a central part of the plasma torch is increased to the temperature of approximately 10,000 °C.

The injection chamber 120 has an approximately cylindrical shape and is connected to a lower end of the heat source 110. Process waste gas is injected into the injection chamber. To this end, a plurality of process waste gas-injecting pipes 121 are connected to the injection chamber 120. In addition, a plurality of catalytic gas-injecting pipes 122 may be further connected to the injection chamber 120 to inject catalytic gas into the injection chamber. An injection angle and location of the process waste gas-injecting pipe 121 and/or the catalytic gas-injecting pipe 122 can be varied independent of regardless of upper and lower sides and right and left sides of the injection chamber.

Here, the catalytic gas may contain ammonia (NH₃). Basically, in addition, process waste gas containing halogen-group elements such as chlorine (Cl) and fluorine (F) and the catalytic gas containing ammonia can be chemically reacted with each other without a supply of heat energy. According to circumstances, therefore, the present invention may not be equipped with the heat source 110.

The reaction chamber 130 is formed into an approximately cylindrical shape and has a circular horizontal sectional shape. The reaction chamber 130 is connected to a lower end of the injection chamber 120, and the catalytic gas is injected into the reaction chamber. To this end, a plurality of catalytic gas-injecting pipes 131 are connected to the reaction chamber 130. Therefore, the catalytic gas is mutually reacted with process waste gas in the reaction chamber 130. Furthermore, since heat energy is supplied from the heat source 110, the catalytic gas and/or process waste gas decomposing and dissociating efficiencies are more enhanced so that the efficiency of mutual reaction between the catalytic gas and process waste gas is also improved. Due to the above, of course, the powder by-product forming efficiency is enhanced by the mutual reaction of the catalytic gas and process waste gas. In other words, the present invention involves the decomposition and dissociation phenomenon of process waste gas caused by the heat energy as well as the catalytic reaction caused by the catalytic gas so that the powder by-product forming efficiency is more improved.

The first cooling unit 140 is formed into an approximately square column (or a hexahedron) shape. In other words, the first cooling unit has a square horizontal sectional shape. The first cooling unit 140 is connected to a lower end of the reaction chamber 130 through an approximately Y-shaped connecting pipe 138. In addition, the first cooling unit 140 may be directly connected to a lower end of the reaction chamber 130 without a separate connecting pipe. This first cooling unit 140 cools rapidly the fluid (process waste gas, the catalytic gas and the powder by-product) to improve the powder by-product collecting efficiency. Here, the first cooling unit 140 includes a first cooling pipe 142b and a second cooling pipe 143b in which cooling fluid (for example, water) flows, these cooling pipes are extended to the filter unit 150. A structure and function of the first cooling unit 140 will be described later.

The filter unit 150 is formed into an approximately cylindrical shape. In other words, the filter unit has a circular horizontal sectional shape. The filter unit 150 is installed at a side of the reaction chamber 130 to filter the powder by-product from the fluid. That is, the filter unit 150 allows the fluid except the powder by-product to pass therethrough. In addition, since the first cooling pipe 142b and the second cooling pipe 143b are connected to the filter unit 150 as described above, a temperature of the filter unit 150 is constantly maintained. A structure and function of the filter unit 150 will be also described later.

Meanwhile, at least one catalytic gas-injection pipe 149 for supplying the catalytic gas connects the first cooling unit 140 and the filter unit 150 to each other. That is, at least one catalytic gas-injection pipe 149 may be mounted to a connecting pipe 148 connecting a lower end of the cooling unit 140 to a lower end of and the filter unit 150. Like the above, the catalytic gas injected into the catalytic gas-injection pipe 149 may contain ammonia (NH₃).

In the present invention as described above, by additionally supplying the catalytic gas to unreacted process waste gas passing through the first cooling unit 140, it is possible to form the powder by-product from unreacted process waste gas once more and to collect the powder by-product. Thus, the scrubber 100 for treating process waste gas according to the present invention has a high powder by-product forming efficiency so that a process waste gas treating efficiency is enhanced.

The second cooling unit 160 has an approximately hexahedral shape and is provided above the filter unit 150. This second cooling unit 160 cools the discharge gas passing through the filter unit 150 to a room temperature (approximately 25 °C) and then discharges it via a discharge pipe 168. If a temperature of the discharge gas passing through the filter unit 150 is sufficiently low, the scrubber of the present invention may not be equipped with the second cooling unit 160, according to circumstances.

Meanwhile, the first cooling unit 140 is connected to the reaction chamber 130 via the Y-shaped connecting pipe 138, and the filter unit 150 is connected to each first cooling unit 140. In other words, a pair of first cooling units 140 and a pair of filter units 150 are provided and these units may be connected to the common cooling unit 160. Therefore, Therefore, even if one set of the first cooling unit 140 and the filter unit 150 are being maintained and repaired, the other set of first cooling unit 140 and the filter unit 150 can be operated so that a halt of operation of the scrubber of the present invention is not generated.

By the above, in addition, the present invention does not require an additional water treating tower besides cooling fluid (cooling water) to provide the environmentally friendly scrubber 100 for treating process waste gas, which does not discharge waste water. Furthermore, the present invention utilizes heat energy to completely decompose/dissociate waste gas and performs a chemical reaction between decomposed/dissociated waste gas and the catalytic gas to convert waste gas into the power-phased substance (powder by-product). As a result, the present invention can lower a discharge concentration of process waste gas. In addition, since the scrubber according to the present invention utilizes only electricity as the power source, it is possible to easily manage the scrubber and to save the operation expense.

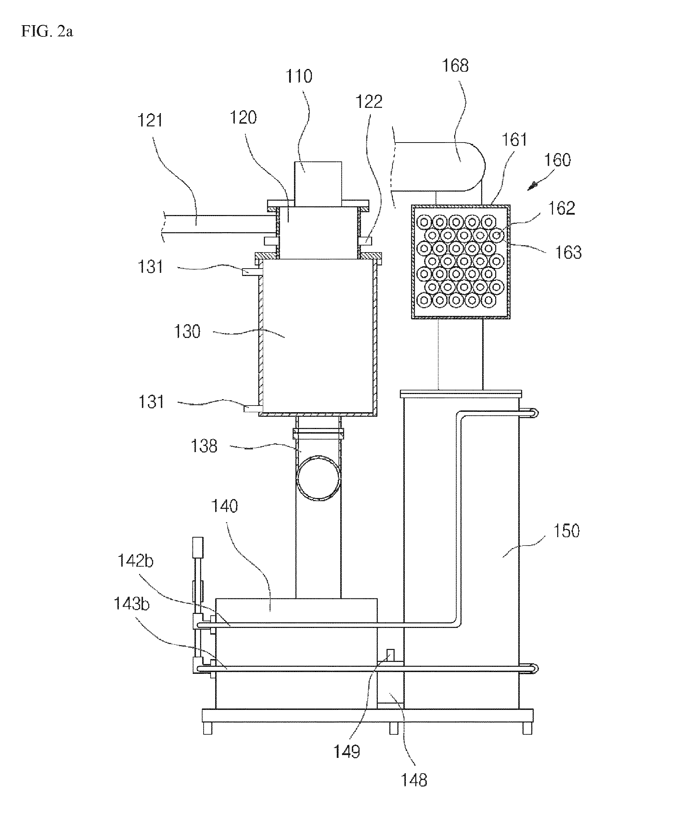

FIG. 2A to FIG. 2C are partial sectional views showing the scrubber 100 for treating process waste gas according to one embodiment of the present invention.

First of all, as shown in FIG. 2A, the process waste gas-injecting pipe 121 having a relatively large diameter and the catalytic gas-injecting pipe 122 having a relatively small diameter may be provided on the injection chamber 120. In addition, the plurality of catalytic gas-injecting pipes 131, each of which having a relatively small diameter, are installed at the reaction chamber 130. The plurality of the catalytic gas-injecting pipes 131 provided on the reaction chamber 130 may be installed at various positions such as an upper end portion and/or a lower end portion of the reaction chamber 130.

Also, the first cooling unit 140 and the filter unit 150 can be connected to each other by means of the first cooling pipe 142b and the second cooling pipe 143b as well as the connecting pipe 148. Thus, the first cooling unit 140 and the filter unit 150 are cooled to and maintained at a certain temperature through the first cooling pipe 142b and the second cooling pipe 143b.

Furthermore, the second cooling unit 160 includes a body 161 having an approximately hexahedral shape and a plurality of cooling pipes 162 provided in the body 161. Here, each of the cooling pipes 162 has a cooling fin 1632 provided in the body 161, and a lengthwise direction of the cooling tube 162 is approximately perpendicular to the flow direction of the discharge gas to allow the cooling tube to cool the discharge gas to a room temperature.

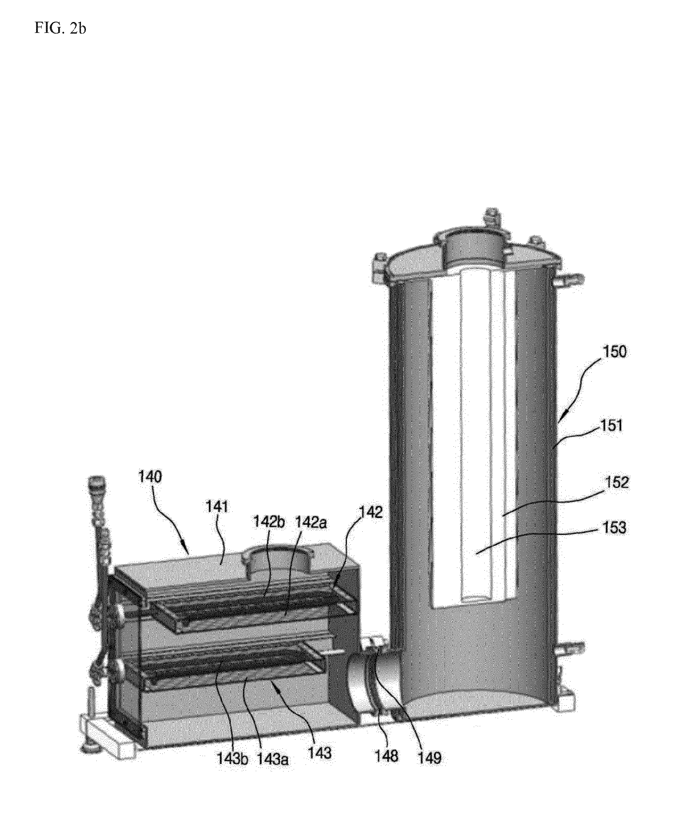

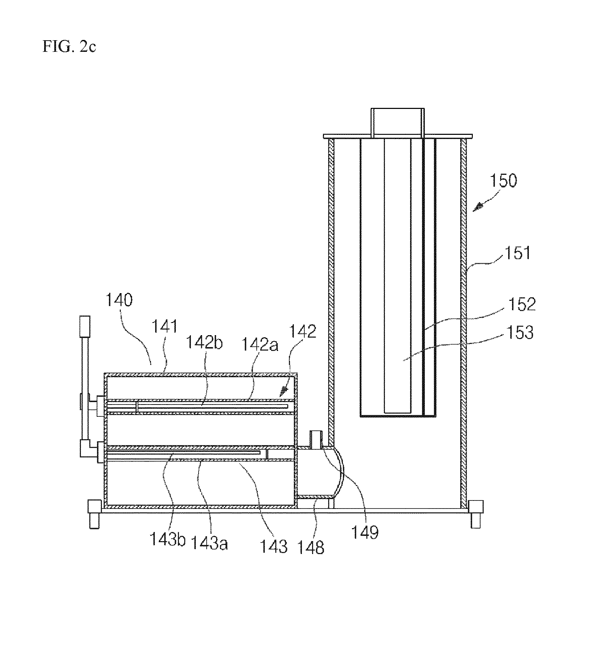

Next, as shown in FIG. 2B and FIG. 2C, the first cooling unit 140 includes a body 141 having an approximately hexahedral shape, a first cooling region 142 and a second cooling region 143, the first and second cooling regions being provided in the body 141. The first cooling region 142 is provided at an upper region of the body 141 and includes a first mesh net 142a having a square frame-shape and the first cooling pipe 142b coupled with the first mesh net 142a. In addition, the second cooling region 143 is provided at a lower region of the body 141 and includes a second mesh net 143a having a square frame-shape and the second cooling pipe 143b coupled with the second mesh net 143a.

Due to the above structure, the powder by-product passing the first cooling region 142 and the second cooling region 143 is in contact with the first mesh net 142a, the first cooling pipe 142b and the second mesh net 143a, the second cooling pipe 143b so that the powder by-product is rapidly cooled and the powder by-product collecting efficiency is more enhanced.

Each of the first mesh net 142a and the second mesh net 143a is a conventional mesh net or flat plate formed by combining wires in the form of lattices, and a perforated plate having a plurality of holes passing vertically therethrough may be utilized as each mesh net.

Meanwhile, one side of the first cooling region 142 is in contact with the body 141 and the other side of the first cooling region is separated from the body 141 by a certain distance. In addition, one side of the second cooling region 143 is separated from the body 141 by a certain distance and the other side of the second cooling region is in contact with the body 141. Therefore, because the fluid passing through the first cooling unit 140 flows along an approximately S-shaped path, a residence time of the fluid in the first cooling unit 140 is lengthened and the fluid smoothly flows even though much powder by-product is accumulated in the first mesh net 142a and the second mesh net 143a.

Also, the filter unit 150 includes a body 151 having a cylindrical shape and a filter 152 provided in the body 151. The cylindrical shaped body 151 is formed into a dual-partition shape to enable the cooling fluid to be stayed between the dual partitions for a certain time. Of course, the first cooling pipe 142b and the second cooling tube 143b are connected to these dual partitions as described above. Furthermore, the filter 152 is formed such that a hollow portion 153 is formed in the filter and the fluid except the powder by-product passes through the filter 152 and is guided in the hollow portion 153. Of course, the hollow portion 153 of the filter 152 is connected to the discharge pipe 168.

As one example, by the above, the present invention utilizes plasma to completely decompose/dissociate waste gas and performs a chemical reaction between decomposed/dissociated waste gas and the catalytic gas to convert waste gas into the power-phased substance. As a result, the present invention can lower a discharge concentration of process waste gas. Besides cooling fluid, the present invention does not require an additional water treating tower besides (cooling water) to prevent waste water from being discharged.

Next, a scrubber for treating process waste gas according to another embodiment of the present invention is illustrated.

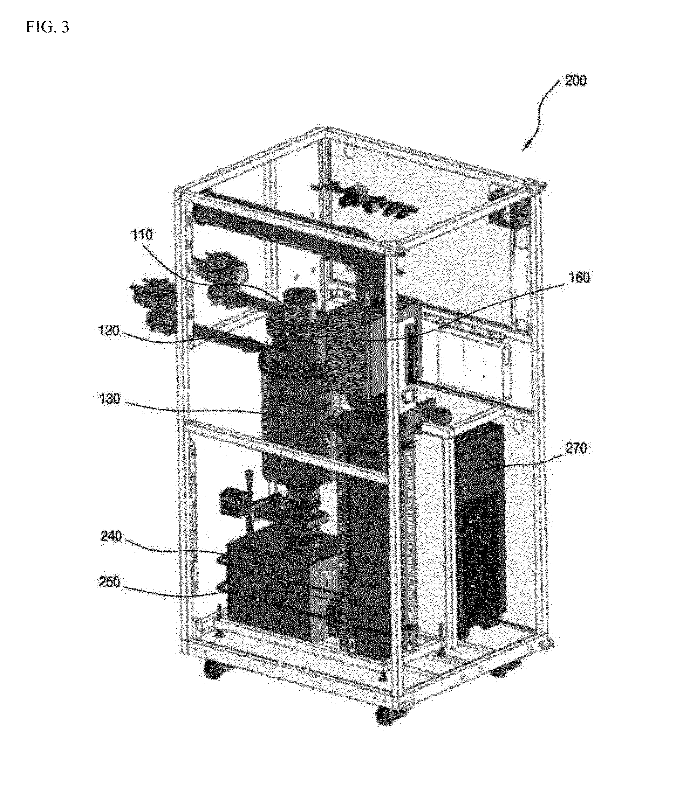

FIG. 3 is a side view showing a scrubber for treating process waste gas according to another embodiment of the present invention.

As shown in FIG. 3, a scrubber 200 for treating process waste gas according to the present invention includes the heat source 110 for providing heat energy, the injection chamber 120 into which process waste gas is supplied, the reaction chamber 130 in which catalytic gas is supplied and is reacted with process waste gas, a first cooling unit 240 in which power by-product is formed, a filter unit 250 for filtering the power by-product and the second cooling unit 160 for cooling discharge gas to a room temperature (approximately 25 °C) and discharging it to an outside. Reference numeral "270" which is not described indicates a power supplying unit for supplying a power to the heat source.

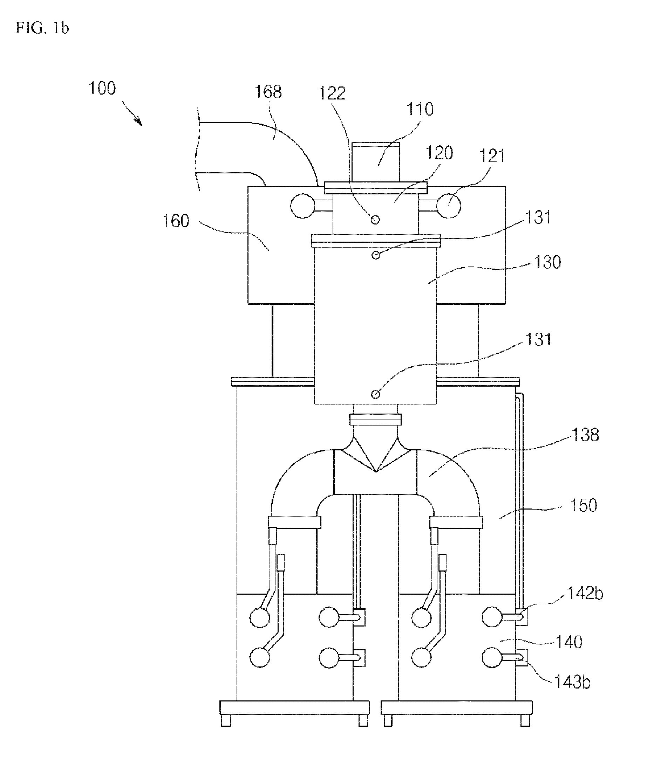

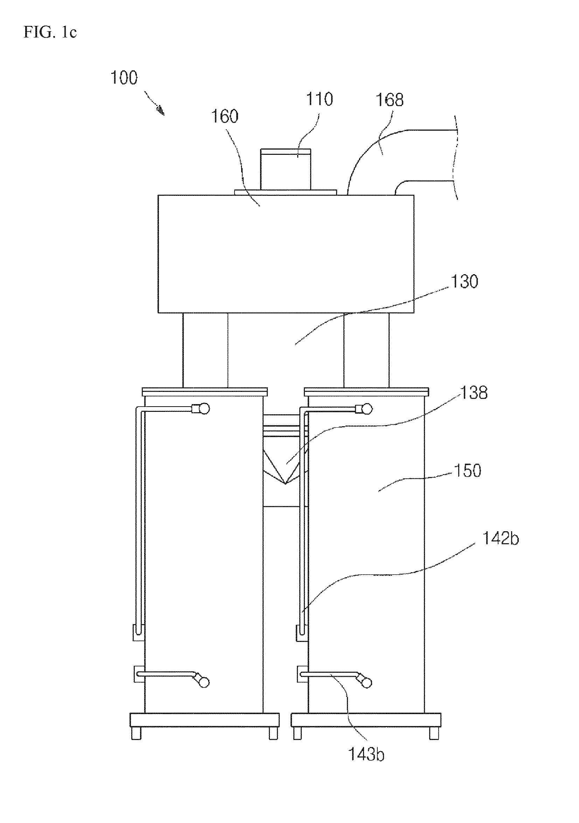

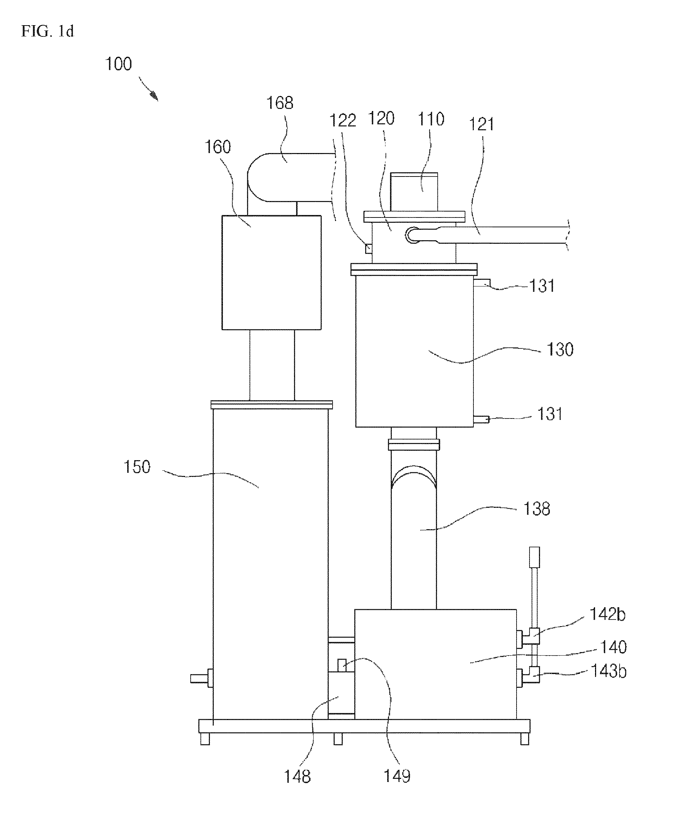

Here, if the above mentioned scrubber 100 is defined as "two chamber trapping system", the scrubber 200 shown in FIG. 1 may be defined as "one chamber trapping system". In other words, while the above stated scrubber 100 is provided with a pair of first cooling units 140 and a pair of filter units 150, the scrubber 200 shown in FIG. 3 is equipped with only one cooling unit 240 and one filter unit 250. To this end, of course, instead of the Y-shaped connecting pipe, the reaction chamber 130 and the first cooling unit 240 are connected to each other via a linear connecting pipe. In addition, the first cooling unit 240 is also connected to the filter unit 250 by means of the linear connecting pipe. Also, structures of the first cooling unit 240 and the filter unit 250 are the same as those of the first cooling unit 140 and the filter unit 150 as described above.

Therefore, the scrubber 200 according to another embodiment of the present invention can minimize a dimension of the overall equipment to minimize an installation area and an installation space.

Next, a scrubber for treating process waste gas according to yet another embodiment of the present invention is illustrated.

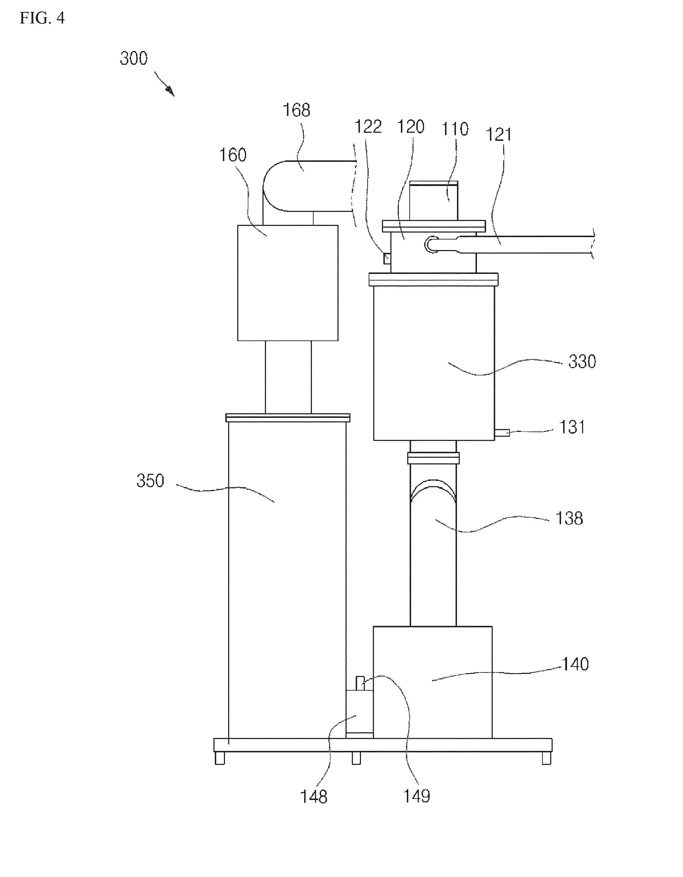

FIG. 4 is a perspective view showing a scrubber for treating process waste gas according to yet another embodiment of the present invention.

As shown in FIG. 4, a scrubber 300 for treating process waste gas according to the present invention includes the heat source 110 for providing heat energy, the injection chamber 120 into which process waste gas is supplied, a reaction chamber 330 in which catalytic gas is supplied and is reacted with process waste gas, a first cooling unit 340 in which power by-product is formed, a filter unit 350 for filtering the power by-product and the second cooling unit 160 for cooling discharge gas to a room temperature (approximately 25 °C) and discharging it to an outside.

Here, in addition to the cylindrical shape as described above, the reaction chamber 330 may have one selected from a square column shape (or a hexahedron with a square-horizontal section), a pentagonal column shape (or a heptahedron with a pentagonal horizontal section), a hexagonal column shape (or an octahedron with a hexagonal horizontal) and a polygonal column shape. Also, besides the square column shape (or a hexahedron), the first cooling unit 340 may have a cylindrical shape. Furthermore, in addition to the cylindrical shape as described above, the filter unit 350 may have one selected from a square column shape (or a hexahedron with a square-horizontal section), a pentagonal column shape (or a heptahedron with a pentagonal horizontal section), a hexagonal column shape (or an octahedron with a hexagonal horizontal) and a polygonal column shape.

In addition, since the reaction chamber 330, the first cooling unit 340 and the filter unit 350 are formed into the various shapes, the scrubber 300 according to another embodiment of the present invention can secure easily a capacity of the chamber required for treating process waste gas.

Since the scrubber for treating process waste gas of the present invention does not utilize separate water besides cooling water circulated therein, waste water is not discharged and additional process for treating waste water is omitted.

The scrubber for treating process waste gas of the present invention utilizes plasma to completely decompose/dissociate waste gas and performs a chemical reaction between dissociated waste gas and the catalytic gas to convert waste gas into the power-phased substance. As a result, the present invention can lower a discharge concentration of process waste gas.

Since the scrubber for treating process waste gas of the present invention utilizes only electricity as the power source and does not use water, it is possible to easily manage the scrubber and to save the operation expense.

While the present invention has been described with respect to the specific embodiments, the present invention is not limited to the above description and drawings, and it will be apparent to those skilled in the art that various changes and modifications may be made without departing from the spirit and scope of the invention as defined in the following claims.

## Claims

1. A scrubber for treating process waste gas, comprising;
a heat source for providing heat energy;
an injection chamber connected to the heat source to allow process waste gas to be injected thereinto;
a reaction chamber connected to the injection chamber and supplying catalytic gas to process waste gas introduced from the injection chamber to decompose process waste gas and form powder by-product;
a first cooling unit connected to the reaction chamber for cooling and collecting the powder by-product; and
a filter unit connected to the first cooling unit for filtering the powder by-product.

2. The scrubber for treating process waste gas of claim 1, wherein process waste gas contains halogen-group elements and the catalytic gas contains ammonia (NH₃).

3. The scrubber for treating process waste gas of claim 1, further comprising a catalytic gas-injecting pipe for supplying the catalytic gas connecting the first cooling unit and the filter unit to each other to collect unreacted process waste gas.

4. The scrubber for treating process waste gas of claim 1, wherein the pair of first cooling units and the pair of filter units are provided.

5. The scrubber for treating process waste gas of claim 1, wherein the heat source is a plasma torch, a gas heater or an electric heater.

6. The scrubber for treating process waste gas of claim 1, wherein the first cooling unit comprises
a first cooling region consisting of first mesh nets and a first cooling pipe installed between the first mesh sheets; and
a second cooling region spaced apart from the first cooling region, the second cooling region consisting of second mesh nets and a second cooling pipe installed between the second mesh sheets.

7. The scrubber for treating process waste gas of claim 6, wherein the first cooling pipe and the second cooling pipe are connected to the filter unit to cool the filter unit.

8. The scrubber for treating process waste gas of claim 6, wherein the cooling fluid is supplied to the first cooling pipe and the second cooling pipe.

9. The scrubber for treating process waste gas of claim 6, wherein the filter unit comprises a filter, the filter is formed such that fluid except for the powder by-product passes through the filter.

10. The scrubber for treating process waste gas of claim 1, further comprising a second cooling unit connected to the filter unit.

11. The scrubber for treating process waste gas of claim 10, wherein the second cooling unit comprises a plurality of cooling pipes on which a cooling fin is installed.

12. The scrubber for treating process waste gas of claim 1, wherein the reaction chamber has a shape selected from a cylindrical shape, a square column shape, a pentagonal column shape, a hexagonal column shape and a polygonal column shape, the first cooling unit is formed into a cylindrical shape or a square column shape, and the filter unit has a shape selected from a cylindrical shape, a square column shape, a pentagonal column shape, a hexagonal column shape and a polygonal column shape.
